# EUROPEAN PATENT APPLICATION

(11) **EP 1 587 227 A2**
(43) Date of publication of application: **19.10.2005**
(21) Application number: 05102791.0
(22) Date of filing: 08.04.2005
(51) Int. Cl.: H04H 1/00

(54) **Method for controlling a memory for time deinterleaving in a receiver for Digital Multimedia Broadcast (DMB)**

(30) Priority: 09.04.2004 KR 2004024533
(71) Applicant: LG ELECTRONICS INC., Seoul (KR)
(72) Inventor: Shin, Jong Woong, Gyeongsangnamdo (KR); Kang, Ik Seon, Pohang-si, Gyeongsangbuk-do (KR)
(74) Representative: Herbjörnsen, Rut

(57) **Abstract**

Provided is a method for controlling a memory for time deinterleaving in a DMB receive by using byte addressing. The memory control method includes the steps of constructing the memory by the several segments so as to store only sample data used for actual time deinterleaving during a time period corresponding to M+1 frames from a time point r through a time point r+M; storing a plurality of sample data at one memory address by accessing the memory on a segment basis through byte addressing; and generating a byte-based memory address according to a time deinterleaving rule determined by the i value, and reading one of the sample data stored at the memory address and masking and another sample data stored at the memory address according to what order sample data is to be read from the memory address, thereby making it possible to greatly reduce the complexity of a memory address decoder in the memory.

## Description

This application claims the benefit of the Korean Application No. 10-2004-0024533 filed on April 9, 2004 which is hereby incorporated by reference.

### BACKGROUND OF THE INVENTION

### Field of' the Invention

The present invention relates to a mobile broadcasting receiver, and more particularly, to a memory control method of applying byte addressing to memory access for time interleaving in a DMB receiver.

### Discussion of the Related Art

Recently, digital audio devices providing high quality sound, such as CD and DVD players, have been popular and accordingly, consumers have been increasingly demanding and requesting the provision of digital broadcasting, which requires high sound quality. Accordingly, in order to overcome the limitations in sound quality of the currently provided frequency modulation (FM) broadcasting, digital audio broadcasting (DAB) is being conducted in Europe, Canada, the United States of America, and many other countries. The provided amplitude modulation (AM) broadcasting or frequency modulation (FM) broadcasting, so as to provide excellent sound quality. The DAB system also provides excellent receiving capacity even while the user is in a mobile state and has the characteristics of transmitting digital data, such as images and short messages, at a high speed. Recently, diversified multimedia services including both audio and video broadcasting are being emphasized, such services are referred to as digital multimedia broadcasting (DMB).

The DMB is robust against noise and distortion on the transmission channel, has high transmission efficiency, and can provide various multimedia services

The DMB adopted by Korea is based on Eureka-147 digital audio broadcasting (DAB) adopted as European ground wave radio standard. In order to enhance more efficiently the reception performance under a moving environment, Reed-Solomon (RS) code and Convolution interleaver that is robust against burst error on the transmission channel are added to the DAB. The added two blocks are applied to DAB ensemble input signal and provide so a low error rate that video service is possible under the moving environment. Specifically, the transmission channel of the DMB broadcasting is a wireless mobile reception channel and its amplitude is time-varying. Also, Doppler spreading of a receive signal spectrum occurs due to the influence of the mobile receiver. Considering the transmission/reception under such a channel environment, the DMB transmission method is based on Coded Orthogonal Frequency Division Multiplexing (OFDM). Since the OFDM scheme uses a plurality of multi-carriers, it is robust against ghost that may occur due to the multi-path. Also, a channel estimation based on pilot signal is convenient.

That is, service signals (audio, video, data service) at the DMB transmitter are respectively encoded and interleaved in time domain so as to prevent error. The service signals interleaved in time domain are multiplexed and combined into main service channel (MSC) serving as data channel. The multiplexed signals are interleaved in frequency domain together with multiplexing configuration information (MCI) and service information (SI), which are transmitted to fast information channel (FIC) serving as control channel. At this point, since the information transmitted to the FIC does not allow time delay, time-domain interleaving is not performed.

The frequency-interleaved bit stream is mapped with differential quadrature phase shift keying (DQPSK) and then converted into OFDM symbol through an inverse fast Fourier transform (IFFT) operation. The OFDM symbol is modulated into RF signal and is then transmitted.

The DMB transmission signal is transmitted with a very low signal intensity compared with an existing analog radio broadcasting signal. Considering the moving reception in a car under a severe fading channel environment such as a city, the signal strength of the actual receive signal is very low.

Accordingly, the DMB receiver must correct transmission error when receiving the receive signal to the maximum under such an inferior reception environment. Also, considering the mobile reception terminal, the most important requisite of the DMB receiver is to provide maximum reception performance at a limited cost.

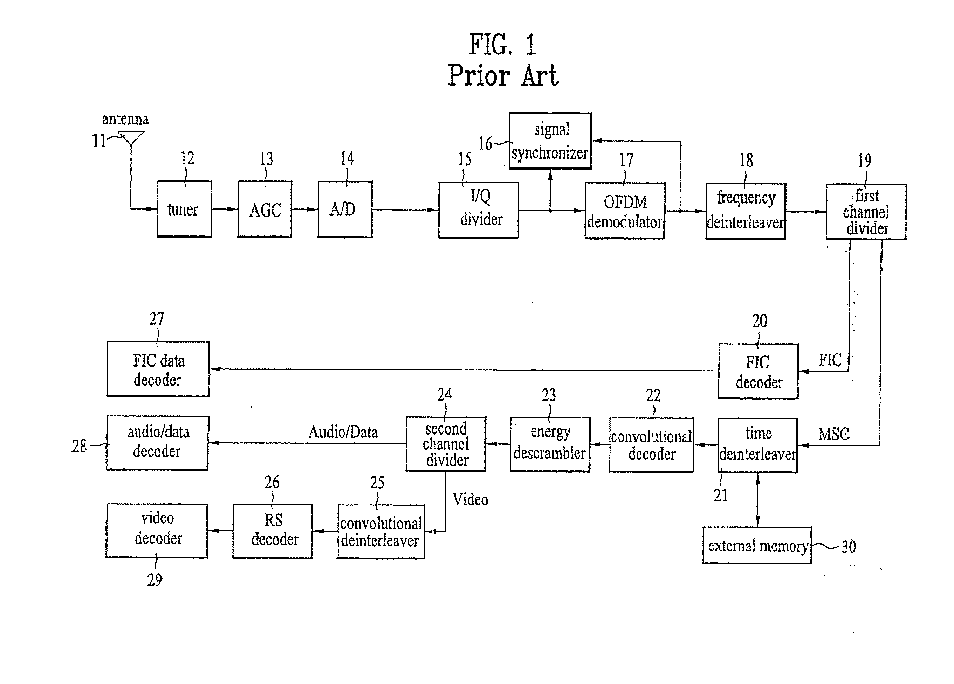

FIG. 1 is a schematic block diagram of a general DMB receiver.

Referring to FIG. 1, a tuner 12 tunes an RF signal of a specific channel among RF signals received through an antenna 11, converts the tuned RF signal into a bandpass IF signal, and then outputs the bandpass signal to an automatic gain control (AGC) block 13. The AGC block 13 amplifies the IF signal to a constant level by multiplying the IF signal by a gain value that is calculated according to a reference signal strength for A/D conversion of the IF signal, and output the amplified (that is, gain-controlled) IF signal to the an A/D converter 14.

The A/D converter 14 converts the gain-controlled IF signal into digital sample data by performing a sampling operation on the gain-controlled IF signal irrespective of the strength of the received signal, and outputs the digital sample data to an I/Q divider 15

The I/Q divider 15 converts the inputted digital sample data having only an inphase (I) component into complex digital sample data (or I/Q digital sample data) having also a quadrature (Q) component, and outputs the complex digital sample data to a signal synchronizer 16 and an OFDM demodulator 17.

The OFDM demodulator 17 removes an unnecessary guard interval from the I/Q digital sample data, converts an time-domain digital sample data into frequency-domain digital sample data through FFT (Fast Fourier Transform), performs differential demodulation and soft decision on the frequency-domain digital sample data, and then not only feedbacks the resulting signal data to the signal synchronizer 16 but also outputs the same to a frequency deinterleaver 18.

At this time, data transmitted from a transmitter is distorted due to various factors such as a noise on a transmission channel. When a receiver receives and OFDM-modulates the distorted data, data different from the transmitted data is obtained.

That is, when data of 1 or 0 is mapped with a predetermined value (for example, 63 and -63) and then transmitted over a transmission channel, the transmitted data is distorted due to a noise of the transmission channel. Accordingly, the receiver must judge the distorted data well. Soft decision is one of methods for judging the distorted data. When data is transmitted from the transmitter and received at a receiver, the soft decision represents how much the received data approaches 1 and 0 by several bits. For example, after a distance difference between an FFTed value and a threshold value is obtained, the obtained valued is quantized and outputted. At this time, the soft decision is called 3-bit soft decision or 4-bit soft decision according to quantization intervals. The 4-bit soft decision represents the distance difference by 15 levels, and one sample data experiencing the 4-bit soft decision becomes 4-bits data.

The signal synchronizer 16 performs frame synchronization, OFDM symbol synchronization, and carrier frequency synchronization by using input and output signals of the OFDM demodulator 17. That is, since a DMB transmitter transmits information on a frame basis, a DMB receiver must first perform the frame synchronization. The OFDM symbol synchronization aims at detecting a start position of an OFDM symbol for accurate demodulation, and the carrier frequency synchronization aims at matching a frequency at a receiver to a carrier frequency at a transmitter.

The frequency deinterleaver 18 receives soft-decided sample data from the OFDM demodulator 17, and deinterleaves the soft-decided sample data in a frequency domain, thereby restoring a sub-carrier signal, which is frequency-deinterleaved at a transmitter, into an original signal. The frequency-deinterleaved data is outputted to a first channel divider 19. The first channel divider 19 divides input data into an FIC channel (a control channel) signal and an MSC channel (data channel) signal, and outputs the FIC channel signal and the MIC channel signal respectively to an FIG. decoder 20 and a time deinterleaver 21.

Here, the FIC channel signal is not time-deinterleaved at the receiver because it was not time-interleaved at the transmitter. The FIC decoder 20 receives the FIC channel signal, extracts, from the FIC channel signal, information necessary for decoding the MSC channel, and finally outputs the extracted information to an FIC data decoder 27. At this time, separate control data transmitted over the FIC channel is restored by the FIC data decoder 27.

Meanwhile, the time deinterleaver 21 restores 16 logical frames of an MSC channel, which is time interleaved in a time domain at the DMB transmitter, into its original order by using an external memory 30. The time deinterleaved MSC channel signal is inputted to a convolutional decoder 22. The convolutional decoder 22 performs Viterbi decoding on the time-deinterleaved MSC channel signal to thereby restore an original value prior to convolutional decoding and correct an random error of the MSC channel. If the error-corrected data has been scrambled, the scrambled data is descrambled at an energy descrambler 23 into original data and then outputted a second channel divider 24. If not, the scrambled data is bypassed by the energy descrambler 23 and then outputted to the second channel divider 24.

The second channel divider 24 divides the received channel signals into a data or audio signal for a DAB service and a video signal for a DMB service, and outputs the data/audio signals and the video signal respectively to an audio/data decoder 28 and a convolutional deinterleaver 28.

The convolutional deinterleaver 25 data additionally interleaved at the transmitter into an original order, and outputs the ordered data to an RS decoder 26. The RS decoder 26 restores data that is RS-encoded at the transmitter, and then outputs the resulting data to a video decoder 29. The video decoder 29 restores a video signal for a DMD service.

Meanwhile, the DMB transmitter performs time-interleaving on service signals (audio, vide and data) so as to randomize a burst error of the received signal. Here, the time-interleaving is a technique that stores received data during a predetermined time period, mixes the received data in a predetermined order different from the received order, and then outputs the mixed data.

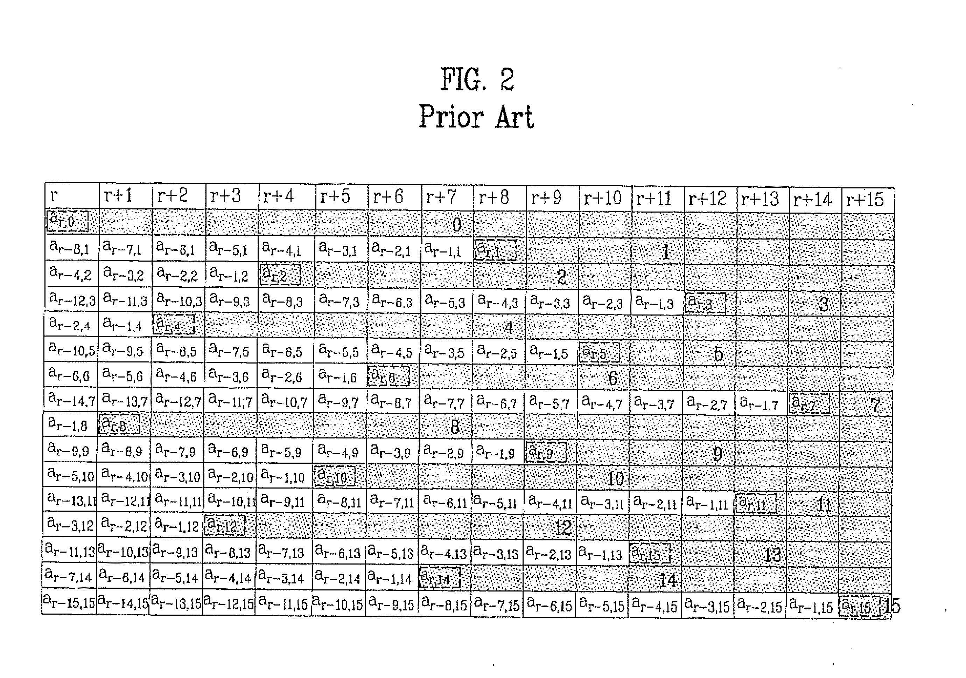

FIG. 2 is a table illustrating a time-interleaving technique according to a general DMD standard.

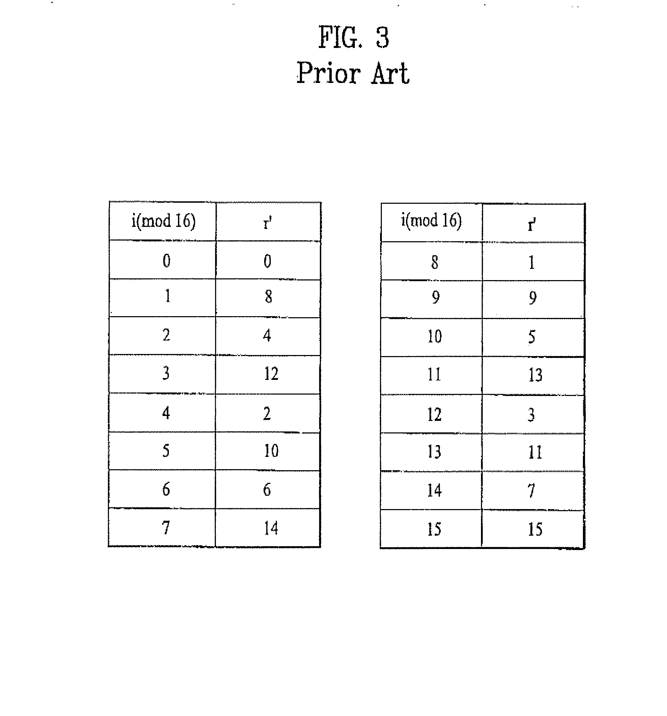

In the time interleaving technique, data of 16 frames are stored in a memory, and then randomized according to a bit reverse rule shown in FIG. 3.

Referring to FIG. 2, data is interleaved during a time period corresponding to 16 frames from a time point r through a time point r+15.

Here, "a_{r,i}" indicates an i^{th} sample data at the time point r.

Original sample data a_{r,i} transmitted at the time point r are interleaved into "a_{r',i}" according to a bit reverse rule shown in FIG. 3 as an i (modulo) value varies from 0 to 15.

At this point, 55296 sample data exist during one frame. Since the value i changes from 0 to 15 by module operation, time interleaving pattern is repeated 3456 times with respect to one frame, as shown in FIG. 2. That is, the same interleaving method is applied at every 16 samples data with respect to each frame.

"r" in FIG. 3 represents the number of the delayed frames

For example, if i=0, "r" is 0. Thus, data inputted at a time point r are outputted without any delay. Also, if i=1, "r" is 8. Thus, data inputted at a time point r are delayed by 8 frames. Therefore, if i=1, data outputted at a time point r are a_{r-8,1,} which correspond to data prior to 8 frames. Data inputted at a time point r are outputted at a time point r+8 (a_{r,1}) after 8-frame delay.

As shown in Fig. 3, in the same manner, the cases of i=2 to i=15, are also delayed by the predetermined number of frames, respectively.

Accordingly, if the receiver intends to recover the time interleaved data, a time deinterleaver is required. Also, a memory for storing data during 16 frames is also required. In the case of the DMB receiver of FIG. 1, an external memory 30 is used for time deinterleaving.

At this point, the time deinterleaving can obtain a_{r,i} from a_{r',i} by a reverse order of the time interleaving process.

According to the DMB standard, since 55296 sample data exist during one frame, the memory for time interleaving within the DMB receiver requires 16×55296×4=3538944 bits in size when soft decision consists of 4 bits.

Also, as shown in FIG. 2, the memory requires 16×16=256 word in size so as to store 16 sample data of each frame during 16 frames.

That is, since one sample data is 4 bits in size, the memory access is achieved by 4-bit addressing. Therefore, when one word of the external memory 30 is 8 bits, the memory requires 16×16×8=2048 bits in size so as to store 16 sample data of each frame during 16 frames, even though one sample data is 4 bits. The memory requires 16×55296×8=7077888 bits in size so as to store 55296 sample data of each frame during 16 frames.

Meanwhile, as the DMB receiver becomes small-sized and expects to be combined with a mobile phone, the DMB receiver chip is also implemented using ASIC technology and is required in a type of one chip solution. Accordingly, the reduction in the size of the memory necessary in the time interleaving has an important meaning because one chip can be achieved by reducing size of gate in the ASIC of the DMB receiver chip.

In the case of the memory for the time interleaving, however, only a hatching portion of FIG. 2 is used during 16 frames according to a bit reverse standard of FIG. 3, while the remaining portions are idle. Therefore, the memory cannot be used efficiently. For example, in FIG. 2, if i=1, data at a time point r to r+7 are data to which the deinterleaving has been done.

### SUMMARY OF THE INVENTION

Accordingly, the present invention is directed to a memory control method for time deinterleaving in a DMB receiver, which substantially obviates one or more problems due to limitations and disadvantages of the related art.

An object of the present invention is to provide a method for controlling a memory for time deinterleaving in a DMB receiver, which can reduce an idle portion of the memory by segmenting and using only an actually-used portion of the memory.

Another object of the present invention is to provide a method for controlling a memory for time deinterleaving in a DMB receiver, which can reduce the complexity of a memory address decoder required in an actual ASIC by accessing the memory through byte addressing.

Additional advantages, objects, and features of the invention will be set forth in part in the description which follows and in part will become apparent to those having ordinary skill in the art upon examination of the following or may be learned from practice of the invention The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a method for controlling a memory of a DMB receiver receiving and time-deinterleaving sample data of respective frames time-interleaved according to i values generated by modulo M, includes the steps of: constructing the memory by the several segments so as to store only sample data used for actual time deinterleaving during a time period corresponding to M+1 frames from a time point r through a time point r+M; and performing time deinterleaving on a segment basis by performing memory read/write access on the sample data according to a time deinterleaving rule determined by the i values.

In another aspect of the present invention, a method for controlling a memory of a DMB receiver receiving and time-deinterleaving sample data of respective frames time-interleaved according to i values generated by modulo 15, includes the steps of: constructing the memory by the several segments so as to store only sample data used for actual time deinterleaving during a time period corresponding to M+1 frames from a time point r through a time point r+15; storing a plurality of sample data at one memory address by accessing the memory on a segment basis through byte addressing; and generating a byte-based memory address according to a time deinterleaving rule determined by the i value, and reading one of the sample data stored at the memory address and masking and another sample data stored at the memory address according to what order sample data is to be read from the memory address.

The memory may be constructed by the 15 segments in the step of constructing the memory so as to store sample data of respective frame from i=0 through i=15, the sample data being time-deinterleaved during a 16-frame period from a time point M through a time point M+1, the size of each segment being changed according to the i values.

The number of sample data used for actual time deinterleaving during a 16-time period from a time point r through a time point r+15 may be determined according to i values in the step of constructing the memory, and the size of each segment in the step of constructing the memory may be determined as an integer obtained by dividing the number of sample data by 2 and founding off a decimal portion of the resulting operation value, the number of the sample data being determined by a corresponding i value.

A segment may not be assigned in the step of constructing the memory if i=15,

The sample data may be stored by taking modulo of a corresponding segment size with respect to sample data inputted on a segment basis.

The step of storing the sample data may include with respect to a specific segment the steps of: (a) determining whether or not an inputted sample data is an odd sample data in a corresponding segment; (b) if the inputted sample data is determined to be an odd sample data in a corresponding segment in the step (a), writing the odd sample data at an n^{th} address of the memory; (c) after completion of the writing of the odd sample data, determining whether or not a next even sample data is inputted; (d) if a next even sample data is determined to be inputted in the step (c), reading data of the n^{th} address of the memory and then converting an upper 4 bit data into the even sample data; (e) rewriting the even sample data at the n^{th} address of the memory; (f) after completion of the step (e), determining whether or not a next odd sample data is inputted; (g) if the next odd sample data is determined to be inputted in the step (f), increasing a memory address by 1 (that is, n=n+1) and then performing the steps (b) to (f) repeatedly; and (h) if no even data exists in the step (c) or if no odd data exists in the step (g), completing an sample data write operation for a corresponding segment.

The step of reading the sample data may include with respect to a specific segment the steps of: generating a byte-based memory address according to a time deinterleaving rule determined by the i value; determining whether sample data to be read from the generated memory address is an even sample data or an odd sample data in a corresponding segment; if the sample data to be read from the generated memory address is an even sample data, reading out an upper 4-bit data from the generated memory address and masking the remaining lower 4-bit; and if the sample data to be read from the generated memory address is an odd sample data, reading out an lower 4-bit data from the generated memory address and masking the remaining upper 4-bit.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:

FIG. 1 is a schematic block diagram of a general DMB receiver;

FIG. 2 illustrates an example of data stored in a memory for time interleaving in a DMB transmitter;

FIG. 3 illustrates an example of a bit reverse rule applied to the time deinterleaving shown in FIG. 2;

FIG. 4 illustrates an example of a memory structure for time deinterleaving in a DMB receiver according to the present invention;

FIG. 5 illustrates a memory structure for time deinterleaving in a DMB receiver according to an embodiment of the present invention;

FIG. 6 is a flow chart illustrating a memory control method for time deinterleaving in a DMB receiver according to an embodiment of the present invention;

FIGs. 7A to 7C are diagrams for comparing memory usage through conventional 4-bit addressing with memory usage through inventive byte addressing; and

FIGs. 8A and 8B illustrate an example of reading a sample data written in a memory through inventive byte addressing

### DETAILED DESCRIPTION OF THE INVENTION

Reference will now be made in detail to the preferred embodiments of the present invention, examples of which are illustrated in the accompanying drawings. Wherever possible, the same reference numbers will be used throughout the drawings to refer to the same or like parts.

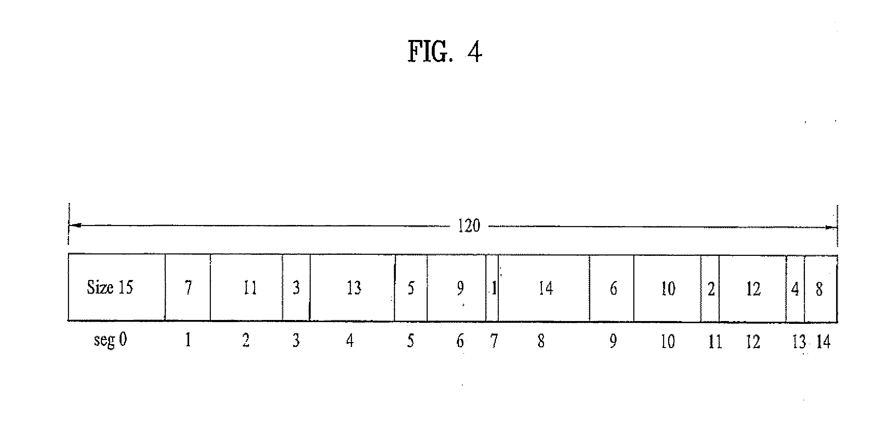

FIG. 4 illustrates a memory structure for time deinterleaving in a DMB receiver according an embodiment of to the present invention. In FIG. 4, a unit of a memory varying in size according to values of "i" is defined as a segment as in FIG. 3.

A memory storing 256 (=16×16) sample data are generally needed in the conventional art when sample data of respective frames (i=0 to i=15) are required to be stored.

However, only a memory storing 120 sample data (a 15-sized segment 0 through an 8-sized segment 14) are needed in the present invention.

Accordingly, a memory size necessary for time deinterleaving can be reduced by 53%. For example, a segment 0 stores 15 sample data of a hatched portion at i=0, and a segment 1 stores 7 sample data of a hatched portion at i=1.

All the samples take the same modulo in general memory usage. However, each segment takes a module corresponding to its size in the inventive multi-segment, whereby an idle portion of a memory can be removed.

In the present invention, time deinterleaving is performed by first reading sample data stored at a specific address and then writing sample data at the same address That is, after sample data of a specific address of the memory is read out and outputted as an output of a time deinterleaver, different sample data for time deinterleaving is written at the same address.

In this manner, since a process where sample data are first read out from a memory of a same address and then different sample data are written at the same address is repeated, the number of necessary memories can be additionally reduced one to each segment. For example, a segment 0 must originally store 16 sample data. However, when sample data are first read out and then written in for the same address, only 15 sample data are stored in the segment 0.

Accordingly, the size of the segment 0 becomes 15 as shown in FIG. 4. Since a segment 15 can be deinterleaved by bypassing an input received in a time deinterleaver, a memory is not separately assigned to the segment 15.

At this time, since memory access is performed through 4-bit addressing also in a memory structure shown in FIG. 4, when a word of a memory is 8 bits, the size of an actual memory for storing sample data of respective frames (i=0 through i=15) during 16 frames becomes 960 (=120×8) bits. Also, since 552960 sample data exit during one frame and a value of 'i' is changed through a modulo operation, the size of an actual memory for storing sample data of respective frames during 16 frames becomes 3317760 (=120×3456×8) bits.

At this time, since the memory is constructed to include an memory address decoder and actual memory cells, when the complexity of the memory address decoder can be reduced, an area required for making a DMB chip in an ASIC type can be greatly reduced.

In another embodiment of the present invention, memory access is performed through byte addressing, whereby a memory size can be further reduced and the complexity of a memory address decoder needed in an actual ASIC can be reduced.

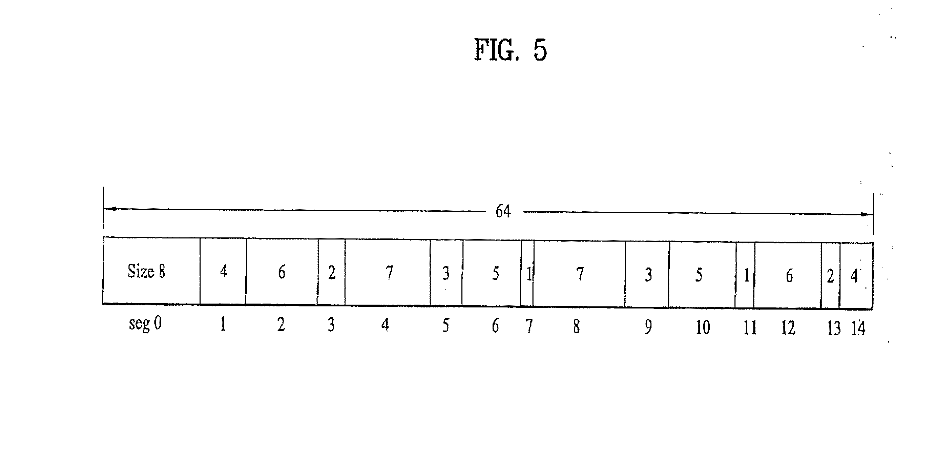

FIG. 5 illustrates a memory structure for time deinterleaving in a DMB receiver according to an embodiment of the present invention, where byte addressing is applied to memory access. Particularly, FIG. 5 illustrates a memory structure for storing time-interleaved sample data from i=0 through i=15 during 15 frames.

In FIG. 5, only a portion used for actual time interleaving is segmented and used.

At this time, when memory access is performed through byte addressing, the size of the total segments becomes 64. Accordingly, when a word of a memory is 8 bits, the size of an actual memory for storing time-interleaved sample data of respective frames (i=0 through i=15) during 16 frames becomes 512 (=64×8) bits. Also, the size of an actual memory for storing sample data of respective frames during 16 frames becomes 1769472 (=64×3456×8) bits.

This is because 2 sample data can be stored at one address of a memory through byte addressing, while only one sample data can be stored at one address of a memory through bit addressing.

Accordingly, the size of a segment 0 becomes 8, the size of a segment 1 becomes 4, the size of a segment 2 becomes 6, the size of a segment 3 becomes 2, the size of a segment 4 becomes 7, and the size of a segment 5 becomes 3. For example, a segment 1 is a memory area in which sample data of i=1 is stored during a time period corresponding to 16 frames from a time point r through a time point r+15, only 8 sample data used for actual time deinterleaving (that is, sample data from a time point r=8 through a time point r+15) is stored in the segment 1.

Also, the size of a segment 6 becomes 5, the size of a segment 7 becomes 1, the size of a segment 8 becomes 7, the size of a segment 9 becomes 3, the size of a segment 10 becomes 5, the size of a segment 11 becomes 1, the size of a segment 12 becomes 6, the size of a segment 13 becomes 2, the size of a segment 14 becomes 4. At this time, since a segment 15 can be deinterleaved by bypassing sample data received in a time deinterleaver 21, a memory is not separately assigned to the segment 15.

When a segment in FIG. 5 is converted into 4-bit addressing, the size thereof becomes a size of 128 that needs a little lager size of a memory core cell than a segment size in an original 4-bit addressing method. However, when a DMB chip is embodied in an actual ASIC, the byte addressing can greatly reduce the complexity of a memory address decoder in comparison with the 4-bit addressing. Accordingly, the byte addressing method can reduce the total area of an ASIC chip.

Also, the present invention constructs a memory for time deinterleaving with several segments (that is, segments 0 through 14), thereby removing an idle portion (that is, a non-hatched portion in FIG. 2) of a memory. This is called a multi-segment method, for convenience in explanation.

All the sample data takes the same modulo (mod 160) in general memory usage. However, each segment takes a modulo corresponding to its size in the inventive multi-segment method, whereby an idle portion of a memory can be removed at time interleaving. For example, a segment 0 takes a mod 15 and a segment 1 takes a mode 7.

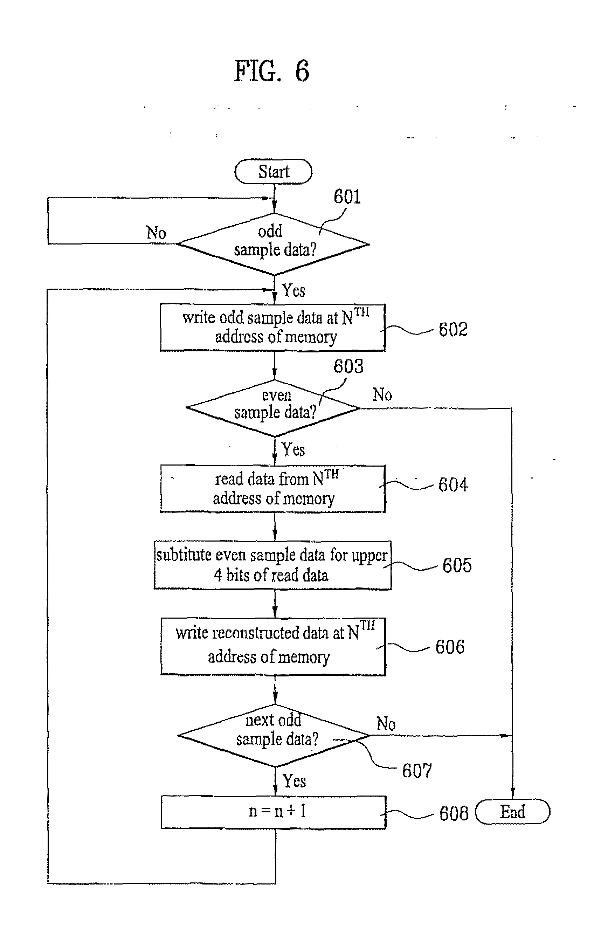

FIG. 6 is a flow chart illustrating a procedure for writing time-interleaved sample data in a memory by accessing the memory through byte addressing, which is a generalization of a write operation in each segment shown in FIG. 5. Here, a unit of a memory varying in size according to values of "i" is defined as a segment.

For example, when one sample data is 4 bits and one word of a memory is 8 bits, 8 memory addresses are necessary for storing, in a segment 0, 15 sample data of i=0 used for an actual time deinterleaving during a 16-frame period, and 4 memory addresses are necessary for storing 7 sample data of i=1 in a segment 1.

When sample data to be stored in a memory is inputted, whether or not the inputted sample data is odd sample dada or even sample data in a corresponding segment is determined (Step 601)

For example, when sample data of i=0 is inputted, whether or not the inputted sample data is odd sample dada or even sample data in a segment 0 is determined.

If the inputted sample data is determined to be odd sample data in Step 601, the odd sample data is written at an n^{th} address of a memory (Step 602). Here, "n" is predesignated as a memory address at which the sample data is to be stored.

Thereafter, whether or not even sample data of i=0 is inputted after the above odd sample data is determined (Step 603). If there exits no even sample data, sample data write operation for a corresponding segment is ended. If there exits even sample data, data of an n^{th} address of the memory is read in (Step 604). This aims at providing against a case where the number of sample data used for an actual time deinterleaving is 7 (that is, an odd number).

Meanwhile, if the odd sample data is 0010, data read in Step 604 becomes xxxx0010.

At this time, data is reconstructed by substituting the even sample data following the odd sample data for the data read in Step 604 (Step 605). For example, if the even sample data is 0100, data reconstructed in Step 605 becomes 01000010.

Then, the reconstructed data is rewritten in an n^{th} address of the memory (Step 606). That is, "01000010" is written at the nth address of the memory. Accordingly, 2 sample data are stored at the n^{th} address ofthc memory.

After Step 606 is performed, whether or not there exists an odd sample data inputted after the even sample data is determined with respect to a corresponding segment (Step 607).

If there exists no sample data (Step 607), a sample data write operation is ended. However, if there exists sample data (Step 607), a memory address is increased by 1 (that is, n=n+1) and then the procedure proceeds to Step 602 (Step 608). In Step 602, the odd sample data inputted in Step 607 is written at the increased memory address, and the procedure proceeds to Step 603.

This procedure is repeated with respect to sample data of i=0 during a time period corresponding to 16 frames from a time point r through a time point r+15, whereby 15 sample data used for an actual time deinterleaving is stored.

Thereafter, 7 sample data of i=1 used for an actual time deinterleaving is stored through a procedure similar to the above-mention.

That is, FIG. 6 is an operational flow chart performed on a segment basis, and memory write operations for sample data of i=0 to i=14 used for an actual time deinterleaving is sequentially performed on a segment basis.

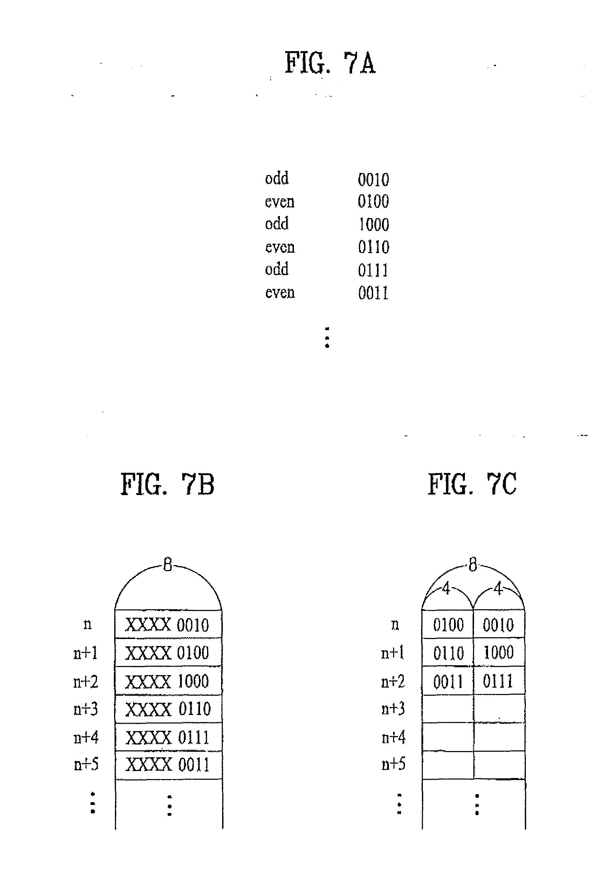

FIGs. 7A to 7C are diagrams for comparing memory usage through the conventional 4-bit addressing with memory usage through the inventive byte addressing.

If it is assumed that data is inputted as shown in FIG. 7A, one sample data is stored at one memory address in the conventional memory usage shown in FIG. 7B, and 2 sample data are stored at one memory address in the inventive memory usage shown in FIG. 7C. Accordingly, it can be known that the inventive method has a high memory usage efficiency

Thereafter, time deinterleaving is performed by reading and outputting sample data stored through the multi-segment method shown in FIG. 6 according to a predetermined deinterleaving rule.

In the present invention, 2 sample data is stored at one memory address through. the byte addressing as shown in FIG. 7C. However, since only one sample data should be read out when the stored data in the memory is read out, it should be known that sample data to be presently read out corresponds to what order sample data in a corresponding segment, which is defined as a segment pointer in the present invention.

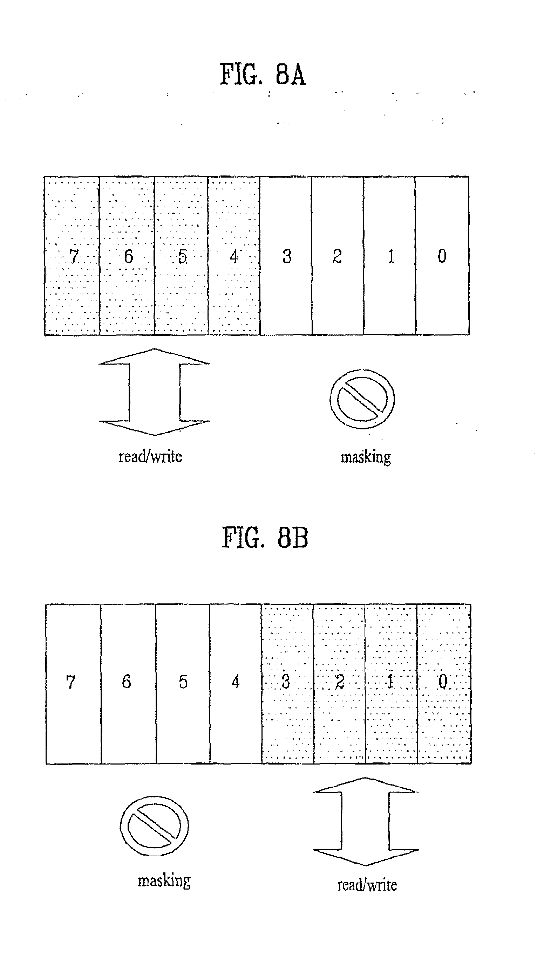

If the segment pointer designates an even number, the upper 4 bits (MSB 4 bits) are read at a corresponding memory address and the lower 4 bits (LSB 4 bits) are masked as shown in FIG. 8A.

Similarly, if the segment pointer designates an odd number, the lower 4 bits (LSB 4 bits) are read at a corresponding memory address and the upper 4 bits (MSB 4 bits) are masked as shown in FIG. 8A.

For example, the size of a segment 0 is originally 15 in the conventional multi-segment method using the 4-bit addressing shown in FIG. 4. However, the size of a segment 0 becomes 8 in the inventive multi-segment method using the byte addressing shown in FIG. 5. Therefore, when an even-numbered segment pointer designates the upper 4-bits and an odd-numbered pointer designates the lower 4-bits, time deinterleaving can be performed as the same method as in the 4-bit addressing.

As described above, the memory control method for time deinterleaving in the DMB receiver can reduce the memory size that is the most important resource in the chip implementation. Also, the reduction in size of gate makes it possible to fabricate the DMB receiver chip in one chip by using ASIC technology. Specifically, the area required for the ASIC of the DMB receiver chip can be greatly reduced by performing the memory access for time deinterleaving through byte addressing. Since the complexity of the memory address decoder among the memory components is greatly reduced, the required area can also be reduced greatly

It will be apparent to those skilled in the art that various modifications and variations can be made in the present invention, Thus, it is intended that the present invention covers the modifications and variations of this invention provided they come within the scope of the appended claims and their equivalents.

## Claims

1. A method for controlling a memory of a DMB receiver receiving and time-deinterleaving sample data of respective frames time-interleaved according to i values generated by modulo M, the method comprising the steps of:
(a) constructing the memory by the several segments so as to store only sample data used for actual time deinterleaving during a time period corresponding to M+1 frames from a time point r through a time point r+M; and
(b) performing time deinterleaving on a segment basis by performing memory read/write access on the sample data according to a time deinterleaving rule determined by the i values.

2. The method of claim 1, wherein the memory has a byte-based address and M is 15.

3. The method of claim 1, wherein the memory is constructed by the 15 segments in the step (a) so as to store sample data of respective frame from i=0 through i=15, the sample data being time-deinteirleaved during a 16-frame period from a time point M through a time point M+1.

4. The method of claim 1, wherein the number of sample data used for actual time deinterleaving during a 16-time period from a time point r through a time point r+15 is determined according to i values in the step (a).

5. The method of claim 1, wherein the size of each segment in the step (a) is changed according to the i values.

6. The method of claim 1, wherein the size of each segment in the step (a) is determined as an integer obtained by dividing the number of sample data by 2 and rounding off a decimal portion of the resulting operation value, the number of the sample data being determined by a corresponding i value.

7. The method of claim 1, wherein a segment is not assigned in the step (a) if i=15.

8. The method of claim 1, wherein the step (b) comprises the steps of:
storing a plurality of sample data at one memory address by accessing the memory on a segment basis through byte addressing; and
generating a byte-based memory address according to a time deinterleaving rule determined by the i value, and reading one of the sample data stored at the memory address and masking and another sample data stored at the memory address according to what order sample data is to be read from the memory address.

9. The method of claim 8, wherein the sample data is stored by taking modulo of a corresponding segment size with respect to sample data inputted on a segment basis.

10. A method for controlling a memory of a DMB receiver receiving and time-deinterleaving sample data of respective frames time-interleaved according to i values generated by modulo M, the method comprising the steps of:
constructing the memory by the several segments so as to store only sample data used for actual time deinterleaving during a time period corresponding to M+1 frames from a time point r through a time point r+M;
storing a plurality of sample data at one memory address by accessing the memory on a segment basis through byte addressing; and
generating a byte-based memory address according to a time deinterleaving rule determined by the i value, and reading one of the sample data stored at the memory address and masking and another sample data stored at the memory address according to what order sample data is to be read from the memory address.

11. The method of claim 10, wherein the memory has a byte-based address and M is 15.

12. The method of claim 11, wherein the memory is constructed by the 15 segments in the step of constructing the memory so as to store sample data of respective frame from i=0 through i=15, the sample data being time-deinterleaved during a 16-frame period from a time point M through a time point M+1, the size of each segment being changed according to the i values.

13. The method of claim 12, wherein the number of sample data used for actual time deinterleaving during a 16-time period from a time point r through a time point r+15 is determined according to i values in the step of constructing the memory.

14. The method of claim 13, wherein the size of each segment in the step of constructing the memory is determined as an integer obtained by dividing the number of sample data by 2 and rounding off a decimal portion of the resulting operation value, the number of the sample data being determined by a corresponding i value.

15. The method of claim 13, wherein a segment is not assigned in the step of constructing the memory if i=15.

16. The method of claim 10, wherein the sample data is stored by taking modulo of a corresponding segment size with respect to sample data inputted on a segment basis.

17. The method of claim 10, wherein the step of storing the sample data comprises with respect to a specific segment the steps of:
(a) determining whether or not an inputted sample data is an odd sample data in a corresponding segment;
(b) if the inputted sample data is determined to be an odd sample data in a corresponding segment in the step (a), writing the odd sample data at an n^{th} address of the memory;
(c) after completion of the writing of the odd sample data, determining whether or not a next even sample data is inputted;
(d) if a next even sample data is determined to be inputted in the step (c), reading data of the n^{th} address of the memory and then converting an upper 4-bit data into the even sample data;
(e) rewriting the even sample data at the n^{th} address of the memory;
(f) after completion of the step (e), determining whether or not a next odd sample data is inputted
(g) if the next odd sample data is determined to be inputted in the step (f), increasing a memory address by 1 (that is, n=n+1) and then performing the steps (b) to (f) repeatedly; and
(h) if no even data exists in the step (c) or if no odd data exists in the step (g), completing an sample data write operation for a corresponding segment,
wherein the above steps are performed on each segment.

18. The method of claim 10, wherein the step of reading the sample data comprises with respect to a specific segment the steps of:
(a) generating a byte-based memory address according to a time deinterleaving rule determined by the i value;
(b) determining whether sample data to be read from the generated memory address is an even sample data or an odd sample data in a corresponding segment;
(c) if the sample data to be read from the generated memory address is determined to be an even sample data in the step (b), reading out an upper 4-bit data from the generated memory address and masking the remaining lower 4-bit; and
(d) if the sample data to be read from the generated memory address is determined to be an odd sample data in the step (b), reading out an lower 4-bit data from the generated memory address and masking the remaining upper 4-bit.

19. The method of claim 18, wherein whether sample data to be read from the generated memory address is an even sample data or an odd sample data in a corresponding segment is determined in the step (b) by using a segment pointer indicating to what order sample data in a corresponding segment the sample data to be presently read out corresponds.
